# EUROPEAN PATENT APPLICATION

(11) **EP 4 611 496 A1**
(43) Date of publication of application: **03.09.2025**
(21) Application number: 24827704.8
(22) Date of filing: 30.12.2024
(51) Int. Cl.: H05K 7/20, H05K 1/11, H01L 23/373

(54) **ELECTRONIC DEVICE COMPRISING HEAT DISSIPATION MEMBER**

(30) Priority: 02.01.2024 KR 20240000410; 17.04.2024 KR 20240051590
(71) Applicant: Samsung Electronics Co., Ltd., Suwon-si, Gyeonggi-do 16677 (KR)
(72) Inventor: NAM, Daehee, Suwon-si, Gyeonggi-do 16677 (KR); KANG, Hanvit, Suwon-si, Gyeonggi-do 16677 (KR); PARK, Sungchul, Suwon-si, Gyeonggi-do 16677 (KR); SHIN, Seungshik, Suwon-si, Gyeonggi-do 16677 (KR); CHOI, Dongkil, Suwon-si, Gyeonggi-do 16677 (KR); HAN, Kwanhee, Suwon-si, Gyeonggi-do 16677 (KR)
(74) Representative: HGF
(86) International application number: PCT/KR2024/021500
(87) International publication number: WO 2025/147045

(57) **Abstract**

The disclosure relates to an electronic device. According to an embodiment of the disclosure, the electronic device may include: a first substrate comprising a first surface and a second surface opposed to the first surface; a second substrate comprising a third surface facing the first surface and a fourth surface opposed to the third surface; an interposer disposed between the first surface and the third surface; an electronic component disposed on the fourth surface; communication circuitry comprising a communication component; one or more power management circuitry comprising switching circuitry and an output capacitor configured to supply power from the switching circuitry to the communication component; and a heat dissipation member, which is in a solid phase at room temperature, disposed in a space defined by the first substrate, the second substrate, and the interposer so as to overlap with the electronic component when viewed in a direction orthogonal to the fourth surface. The output capacitor of the one or more power management circuitry may be disposed on the first substrate or the second substrate and may not overlap with the heat dissipation member when viewed in a direction orthogonal to the fourth surface.

## Description

### [Technical Field]

The disclosure relates to an electronic device, for example, to an electronic device comprising a heat dissipation structure for an electronic component.

### [Background Art]

Electronic devices may refer to devices that perform specific functions based on embedded programs, such as home appliances, electronic notes, portable multimedia players (PMPs), mobile communication terminals, tablet personal computers (PCs), video/audio devices, desktop/laptop computers, vehicle navigation systems, and so forth. For example, these electronic devices may output stored information in the form of sound or images.

With the increasing integration of electronic devices and the common use of ultra-high-speed and large-volume wireless communication, various functions have recently come to be provided in a single electronic device, such as a mobile communication terminal. For example, various functions such as an entertainment function such as gaming, a multimedia function such as music/video playback, a communication and security function for mobile banking, and a function such as a schedule management or electronic wallet, as well as a communication function have been integrated into a single electronic device. Such electronic devices have become compact such that users can conveniently carry them.

### [Disclosure of Invention]

### [Solution to Problems]

According to an embodiment of the disclosure, the electronic device may include a first substrate including a first surface and a second surface opposed to the first surface.

According to an embodiment of the disclosure, the electronic device may include a second substrate including a third surface facing the first surface and a fourth surface opposed to the third surface.

According to an embodiment of the disclosure, the electronic device may include an interposer disposed between the first surface and the third surface.

According to an embodiment of the disclosure, the interposer may at least partially surround the heat dissipation member.

According to an embodiment of the disclosure, the electronic device may include an electronic component disposed on the fourth surface.

According to an embodiment of the disclosure, the electronic device may include communication circuitry including a communication component.

According to an embodiment of the disclosure, the electronic device may include one or more power management circuitry including switching circuitry.

According to an embodiment of the disclosure, the power management circuitry may include an output capacitor configured to supply power provided by the switching circuitry to the communication component.

According to an embodiment of the disclosure, the electronic device may include a heat dissipation member that is in a solid phase at room temperature.

According to an embodiment of the disclosure, the heat dissipation member may be disposed in a space defined by the first substrate, the second substrate, and the interposer to overlap the electronic component when viewed in a direction orthogonal to the fourth surface.

According to an embodiment of the disclosure, the output capacitor of the one or more power management circuitry may be disposed on the first substrate or the second substrate.

According to an embodiment of the disclosure, the output capacitor of the one or more power management circuitry may be disposed on any of the first surface, the second surface, the third surface, or the fourth surface.

According to an embodiment of the disclosure, the output capacitor of the one or more power management circuitry may not overlap the heat dissipation member when viewed in a direction orthogonal to the fourth surface.

### [Brief Description of the Drawings]

FIG. 1 is a block diagram of an electronic device within a network environment according to various embodiments;
FIG. 2 is a perspective view of an electronic device illustrating the front surface of the electronic device according to an embodiment of the disclosure;
FIG. 3 is an exploded perspective view of an electronic device illustrating the front surface of the electronic device according to an embodiment of the disclosure;
FIG. 4 is a cross-sectional view of a substrate assembly taken along line A-A' shown in FIG. 3, according to an embodiment of the disclosure;
FIG. 5 is a partial block diagram of an electronic device illustrating communication circuitry and power management circuitry of the electronic device according to an embodiment of the disclosure;
FIG. 6 is a schematic diagram of the power management circuitry illustrated in FIG. 5, according to an embodiment of the disclosure;
FIG. 7 is a plan view of part of a substrate assembly according to an embodiment of the disclosure;
FIG. 8 is a cross-sectional view of the substrate assembly according to an embodiment of the disclosure;
FIG. 9 is a plan view of the first substrate and the second substrate according to another embodiment of disclosure;
FIG. 10 is a plan view of the first substrate according to an embodiment of the disclosure;
FIG. 11 is a plan view of part of a substrate assembly according to an embodiment of the disclosure; and
FIG. 12 illustrates part of the process of manufacturing a substrate assembly according to an embodiment of the disclosure.

### [Mode for the Invention]

The following description taken in conjunction with the accompanying drawings may provide an understanding of various exemplary implementations of the disclosure, including claims and their equivalents. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope and spirit of the disclosure, such as the additional or omission of any components, and the combination of different implementations/embodiments and the features thereof. Further, descriptions of well-known functions, components, and/or configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims and equivalent thereto.

The singular forms "a," "an," and "the" are intended to include the plural forms as well, unless the context clearly indicates otherwise. Thus, as an example, "a component surface" may be interpreted as including one or more of the surfaces of a component.

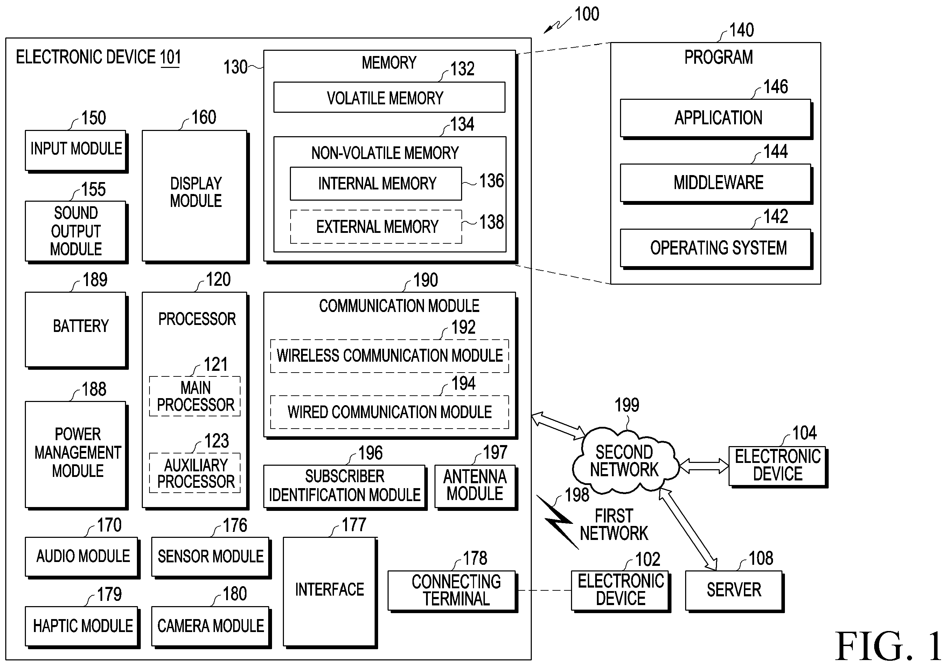

FIG. 1 is a block diagram illustrating an electronic device in a network environment 100 according to various embodiments of the disclosure.

Referring to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). According to an embodiment, the electronic device 101 may communicate with the external electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. In an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least portion of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as portion of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as portion of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as portion of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a second sensor module configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. According to an embodiment, the interface 177 may include, for example, a high-definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the external electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least portion of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as BluetoothTM, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the external electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other portions (e.g., radio frequency integrated circuit (RFIC)) than the radiator may be further formed as portion of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least portion of the function or the service. The one or more external electronic devices receiving the request may perform the at least portion of the function or the service requested, or an additional function or an additional service related to the request, and transfer an outcome of the performing to the electronic device 101. The electronic device 101 may provide the outcome, with or without further processing of the outcome, as at least portion of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

The electronic device according to various embodiments of the disclosure may be one of various types of devices. The electronic devices may include, for example, a portable communication device (e.g., a smartphone), a computer device, a portable multimedia device, a portable medical device, a camera, a wearable device, or a home appliance. The electronic devices according to an embodiment are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in the various embodiments of the disclosure, the term "module" may include a unit implemented in hardware, software, or firmware, and may interchangeably be used with other terms, for example, "logic," "logic block," "portion," or "circuitry". A module may be a single integral component, or a minimum unit or portion thereof, adapted to perform one or more functions. For example, according to an embodiment, the module may be implemented in a form of an application-specific integrated circuit (ASIC).

Various embodiments of the disclosure may be implemented as software (e.g., the program 140) including one or more instructions that are stored in a storage medium (e.g., internal memory 136 or external memory 138) that is leadable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium leadable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-leadable storage medium (e.g., compact disc lead only memory (CD-ROM)), or be distributed (e.g., downloaded or uploaded) online via an application store (e.g., Play StoreTM), or between two user devices (e.g., smartphones) directly. If distributed online, at least portion of the computer program product may be temporarily generated or at least temporarily stored in the machine-leadable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

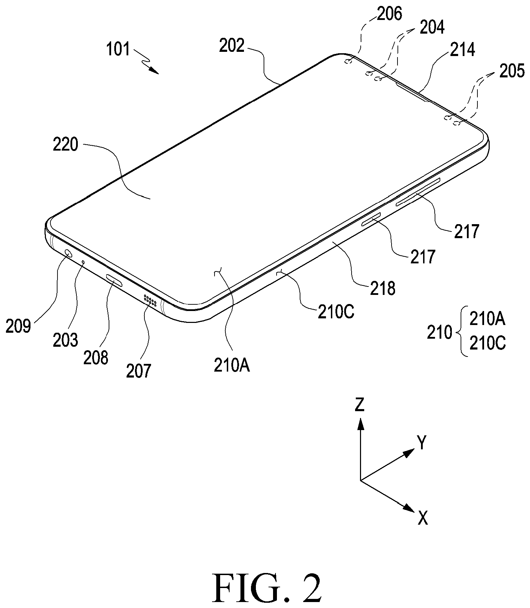

FIG. 2 is a perspective view illustrating a front surface 210A of an electronic device 101 according to an embodiment of the disclosure.

Referring to FIG. 2, the electronic device 101 according to an embodiment of the disclosure may include a first surface (or front surface) 210A, a second surface (or rear surface) (not shown), and a third surface (or side surface) 210C surrounding a space between the first surface 210A and the second surface 210B.

According to an embodiment of the disclosure, the first surface 210A may be formed by a front plate 202 (e.g., a glass plate or a polymer plate including various coating layers) that is substantially transparent or at least a partial portion is substantially transparent. The second surface (or rear surface) (not shown) may be formed by a rear plate (not shown) that is substantially opaque. The side surface 210C may be coupled to the front plate 202 and the rear plate 211 and formed by a side structure (or a "side bezel structure") 218 including a metal and/or a polymer.

According to an embodiment of the disclosure, the electronic device 101 may include at least one of a display 220, audio modules 203, 207, and 214, a sensor module 204, a key input device 217, a light emitting device 206, and connector holes 208 and 209.

According to an embodiment of the disclosure, the display 220 may be visually exposed, for example, through a significant portion of the front plate 202. **In an** embodiment, at least a portion of the display 220 may be visually exposed through the front plate 202 forming the first surface 210A or through a portion of the side surface 210C. In an embodiment, the edge of the display 220 may be formed to be substantially the same in shape as an adjacent outer edge of the front plate 202.

According to an embodiment of the disclosure, the audio modules 203, 207, and 214 may include a microphone hole 203 and speaker holes 207 and 214. The microphone hole 203 may have a microphone inside to obtain external sounds, and in an embodiment, there may be a plurality of microphones to be able to detect the direction of a sound. The speaker holes 207 and 214 may include an external speaker hole 207 and a phone receiver hole 214. In an embodiment, the speaker holes 207 and 214 and the microphone hole 203 may be implemented as a single hole, or speakers may be rested without the speaker holes 207 and 214 (e.g., a piezo speaker).

According to an embodiment, the sensor module 204 may generate an electrical signal or a data value corresponding to an internal operating status or an external environmental state of the electronic device 101. The sensor module 204 may include, for example, a first sensor module 204 (e.g., a proximity sensor) disposed on the first surface 210A of the housing 210 and/or a second sensor module (not shown) (e.g., a fingerprint sensor). The fingerprint sensor may be disposed on the second surface (not shown) or the side surface 210C as well as on the first surface 210A (e.g., the display 220) of the housing 210. The electronic device 101 may further include, for example, at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment of the disclosure, the camera device 205 may be disposed on the first surface 210A of the electronic device 101. The camera device 205 may include one or more lenses, an image sensor, and/or an image signal processor.

According to an embodiment of the disclosure, the key input device 217 may be disposed on the side surface 210C of the housing 210. In an embodiment, the electronic device 101 may not include some or all of the above-mentioned key input devices 217, and the excluded key input devices 217 may be implemented in other forms, such as soft keys, on the display 220.

According to an embodiment of the disclosure, the light emitting element 206 may be disposed, for example, on the first surface 210A of the housing 210. The light emitting device 206 may provide, for example, status information of the electronic device 101 in the form of light. In an embodiment, the light emitting device 206 may provide a light source that is, for example, interlinked with the operation of the camera module 205. The light emitting device 206 may include, for example, an LED, an IR LED, and a xenon lamp.

The connector holes 208 and 209 may include a first connector hole 208 configured to accommodate a connector (e.g., a USB connector) for transmitting and receiving power and/or data to and from an external electronic device, and/or a second connector hole 209 configured to accommodate a connector (e.g., an earphone jack) for transmitting and receiving audio signals to and from an external electronic device.

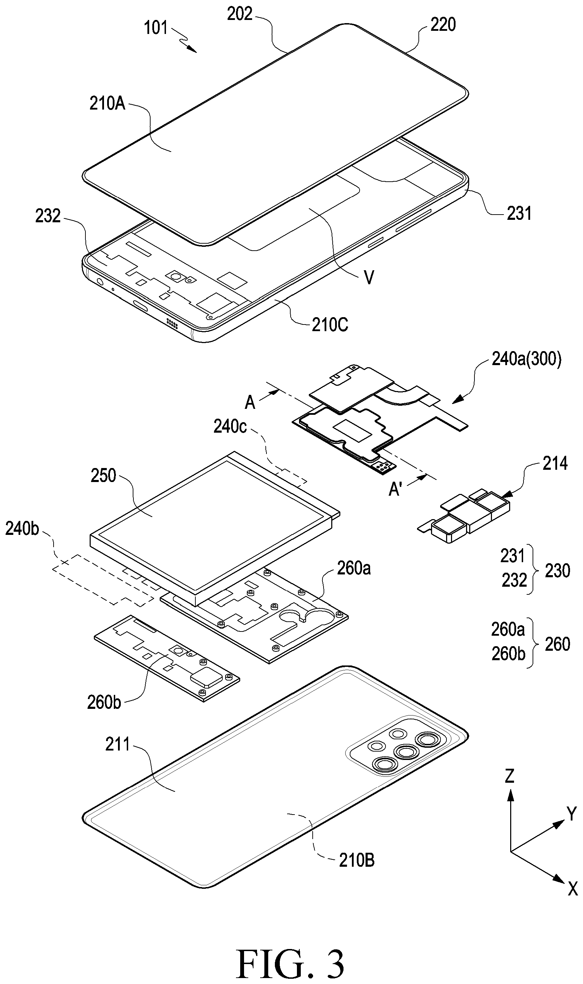

FIG. 3 is an exploded perspective view of a front surface of the electronic device 101 according to an embodiment of the disclosure.

Referring to FIG. 3, the electronic device 101 according to an embodiment of the disclosure may include a side structure 231, a first support member 232 (e.g., a bracket), a display 220, at least one printed circuit board (or substrate assembly) 240a and 240b, a battery 250, a second support member 260, an antenna, a camera assembly 214, and a rear plate 211. When a plurality of printed circuit boards 240a and 240b are included, the electronic device 101 may include at least one flexible printed circuit board 240c to electrically connect different printed circuit boards. For example, the printed circuit boards 240a and 240b may include a first substrate assembly 240a disposed on one side (e.g., the upper side or Y direction) of the battery 250 and a second substrate assembly 240b disposed on the other side (e.g., the lower side or -Y direction) of the battery 250, wherein the first substrate assembly 240a and the second substrate assembly 240b may be electrically connected by the flexible printed circuit board 240c.

According to an embodiment of the disclosure, at least a portion of the first support member 232 may be provided in a flat plate shape. In an embodiment, the first support member 232 may be disposed inside the electronic device 101 to be connected to the side structure 231 or integrated with the side structure 231. The first support member 232 may be formed of, for example, a metallic material and/or a nonmetallic material (e.g., polymer). When the first support member 232 is at least partially formed of a metallic material, a portion of the side structure 231 or the first support member 232 may function as an antenna. The display 220 may be coupled to one surface (e.g., in the Z direction) of the first support member 232, and the substrate assemblies 240a and 240b may be coupled to the opposite surface (e.g., in the -Z direction) thereof. The substrate assemblies 240a and 240b may include, for example, an interposer, a processor, memory, and/or an interface. The processor may include, for example, one or more of a central processing unit, an application processor, a graphics processing unit, an image signal processor, a sensor hub processor, or a communication processor.

According to an embodiment of the disclosure, the front plate 202 may be coupled to the support member 232 through an adhesive member. The front plate 202 may be referred to as a "cover" or a "front cover". The rear plate 211 may be referred to as a "cover" or a "rear cover". The edge of the cover 211 may be supported by the support member 232.

According to an embodiment of the disclosure, the first support member 232 and the side structure 231 may be combined and referred to as a front case or a housing 230. The housing 230 may also be referred to as a frame 230. According to an embodiment, the housing 230 may accommodate the substrate assembly 240a or 240b or the battery 250.

In an embodiment of the disclosure, the housing 230 may form at least a portion of the exterior of the electronic device 101. The housing 230 may include a side structure 231, a first support member 232, a front plate 202, and a rear plate 211. In an embodiment of the disclosure, the term "front surface or rear surface of the housing 230" may refer to the front plate 202 or the rear cover 211. In an embodiment, the first support member 232 may be disposed between the front plate 202 and the rear plate 211, and may function as a structure for placing electrical/electronic components such as the substrate assemblies 240a and 240b or the camera assembly 214.

According to an embodiment of the disclosure, the interface may include, for example, a high definition multimedia interface (HDMI), a universal serial bus (USB) interface, an SD card interface, and/or an audio interface. The interface may, for example, electrically or physically connect the electronic device 101 to an external electronic device and may include a USB connector, an SD card/MMC connector, or an audio connector.

According to an embodiment of the disclosure, the second support member 260 may include, for example, an upper support member 260a and a lower support member 260b. In an embodiment, the upper support member 260a may be disposed to surround the substrate assemblies 240a and 240b (e.g., the first substrate assembly 240a) along with a portion of the first support member 232. For example, the upper support member 260a of the second support member 260 may be disposed to face the first support member 232, with the first substrate assembly 240a interposed therebetween.

In an embodiment of the disclosure, the lower support member 260b of the second support member 260 may be disposed to face the first support member 232 with the second substrate assembly 240b interposed therebetween. A circuit device (e.g., a processor, a communication module, or memory) implemented in the form of an integrated circuit chip or various electrical/electronic components, may be disposed on the printed circuit boards 240a and 240b, and according to an embodiment, the printed circuit boards 240a and 240b may be provided with an electromagnetic shielding from the second support member 260. In an embodiment, the lower support member 260b may be used as a structure for placing electrical/electronic components such as a speaker module and an interface (e.g., a USB connector, an SD card/MMC connector, or an audio connector).

In an embodiment of the disclosure, electrical/electronic components such as a speaker module and an interface (e.g., a USB connector, an SD card/MMC connector, or an audio connector) may be disposed on an additional printed circuit board (not shown). For example, the lower support member 260b may be disposed to surround an additional printed circuit board, along with another portion of the first support member 232.

According to an embodiment, the battery 250 is a device supplying power to at least one component of the electronic device 101, and may include, for example, a non-rechargeable primary cell, a rechargeable secondary cell, or a fuel cell. At least a portion of the battery 250 may be disposed on substantially the same plane as, for example, the printed circuit boards 240a and 240b. The battery 250 may be integrally disposed inside the electronic device 101 or may be detachably disposed within the electronic device 101.

Although not shown, the antenna may include a conductor pattern implemented on the surface of the second support member 260, for example, through laser direct structuring. In an embodiment, the antenna may include a printed circuit pattern formed on the surface of a thin film, and the thin film-type antenna may be disposed between the rear plate 211 and the battery 250. The antenna may include, for example, a near field communication (NFC) antenna, a wireless charging antenna, and/or a magnetic secure transmission (MST) antenna. The antenna may enable short-range communication with, for example, an external device or may wirelessly transmit and receive power required for charging. In an embodiment, another antenna structure may be formed by a part or a combination of the side structure 231 and/or the first support member 232.

According to an embodiment of the disclosure, the electronic device 101 may include a heat dispersion member (V). For instance, the heat dispersion member (V) may be disposed on the first support member 232. Heat generated inside the electronic device 101 may be dispersed through the heat dispersion member (V) or emitted to the outside of the electronic device 101. For example, heat generated by the first substrate assembly 240a may be transferred to the battery 250 through the heat dispersion member. The heat dispersion member may include, for example, a vapor chamber or a heat pipe.

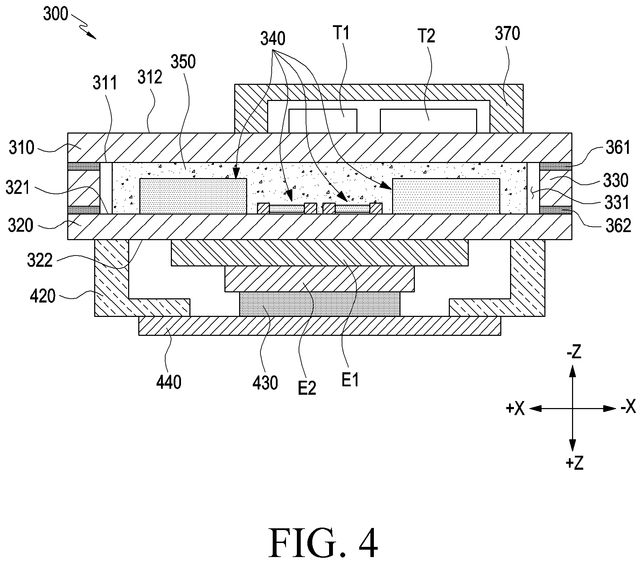

FIG. 4 is a cross-sectional view of a substrate assembly 300 taken along line A-A' shown in FIG. 3, according to an embodiment of the disclosure. By way of example, the features of the first substrate assembly 240a described with reference to FIG. 3 may be applied substantially identically to the substrate assembly 300 shown in FIG. 4, to the extent that they do not conflict with each other.

The Z-axis (+Z, -Z) shown in FIG. 4 may correspond to the Z-axis shown in FIGS. 2 and 3. The +Z direction shown in FIG. 4 may be the same as the direction in which the Z-axis in FIG. 3 is oriented, and the -Z direction shown in FIG. 4 may be the same as the direction opposite to the direction in which the Z-axis in FIG. 3 is oriented.

Referring to FIG. 4, the substrate assembly 300 according to an embodiment of the disclosure may include a first substrate 310. The first substrate 310 may include a first surface 311 and a second surface 312 opposite to the first surface 311 (i.e. facing away from each other). As an example, the first substrate 310 may include a printed circuit board, on which at least one electrical element (component) is mounted, on the first surface 311 and/or the second surface 312. In some examples the first substrate may be a printed circuit board and have one or more electrical elements mounted on the first surface 311 and/or the second surface 312.

A substrate assembly 300 according to an embodiment of the disclosure may include a second substrate 320. The second substrate 320 may include a third surface 321 facing the first surface 311 of the first substrate 310. The second substrate 320 may also include a fourth surface 322 opposite to the third surface 321 (i.e. facing away from each other). For example, the second substrate 320 may include a printed circuit board, on which at least one electrical element is mounted, on the third surface 321 and the fourth surface 322. In some examples the second substrate may be a printed circuit board and have one or more electrical elements mounted on the third surface 321 and/or the fourth surface 322.

According to an embodiment of the disclosure, the electronic device 101 may include a heat dissipation member 350 disposed between the first surface 311 of the first substrate 310 and the third surface 321 of the second substrate 320. The heat dissipation member 350 may be in contact, either partially or fully, with the first surface 311 and/or the third surface 321. A portion of the heat dissipation member 350 may be in contact with the third surface 321 between the components 340 arranged on the third surface 321. Components may also be arranged on the first surface and a portion of the heat dissipation member 350 may be in contact with the first surface 311 between components arranged on the first surface 311.

According to an embodiment of the disclosure, the heat dissipation member 350 may be in contact with the first surface 311 of the first substrate 310. The heat dissipation member 350 may be in contact with the third surface 321 of the second substrate 320. The heat dissipation member 350 may be in contact with at least one of the components 340 disposed on either the first surface 311 or the third surface 321.

According to an embodiment of the disclosure, the heat dissipation member 350 may be disposed on the first surface 311 of the first substrate 310. The heat dissipation member 350 may be attached to the first surface 311. As an example, an adhesive layer may be disposed between the first surface 311 and the heat dissipation member 350. For example, the adhesive layer may include an adhesive made of acrylic material or hot melt material. In other examples, the heat dissipation member 350 may be attached to the third surface 321 via an adhesive. In some examples, the heat dissipation member 350 may have adhesive qualities that can attach it to first surface 311 and/or the third surface 321.

According to an embodiment of the disclosure, the heat dissipation member 350 may be in a solid phase at room temperature. For example, the room temperature Tr may be in the range of 15°C to 25°C. The heat dissipation member 350 may also be in a solid phase at the operating temperature (e.g., 45°C to 65°C) of the electronic component E1. The heat dissipation member 350 may gradually soften as the temperature increases. For example, when the electronic component E1 operates, the temperature of the heat dissipation member 350 rises due to the heat generated by the electronic component E1, and accordingly, the heat dissipation member 350 may change to a softer solid or gel phase compared to when it is at room temperature.

According to an embodiment of the disclosure, the heat dissipation member 350 may exhibit thermoresponsive behavior, allowing its physical properties, such as phase or thermal conductivity, to alter in response to temperature of the heat dissipation member 350. For instance, at room temperature, the heat dissipation member 350 may remain in a solid phase, but when the heat dissipation member 350 is heated by absorbing ambient heat, the heat dissipation member 350 transitions into a gel phase. Transition of the phase enhances heat dissipation efficiency of the heat dissipation member 350. The heat dissipation member 350 may comprise a heat dissipation material, phase change material (PCM), and a matrix material. Further details regarding materials included in the heat dissipation member 350 are provided below.

According to an embodiment of the disclosure, when the heat dissipation member 350 is in a solid phase at room temperature, it may be easier to transport, position, or assemble the heat dissipation member 350 compared to when it is in a liquid or gel phase. Additionally, when the heat dissipation member 350 is in a solid phase, it may have a certain level of rigidity, which can reduce defects such as dents or compressions that may occur during the assembly or transportation process. Furthermore, providing the heat dissipation member as a solid at room temperature and/or during deposition during manufacture of the electronic device, may avoid the use of a liquid heat dissipation material during manufacture which can make placement easier and/or avoid the need for injection/observation/exhaust holes in the one or more substrates or other components. Furthermore, design freedom may be increased since the placement of the heat dissipation material may be easier to control thus making it easier to contain with certain spaces/areas, therefore allowing components to be positioned with less regard for the effect it may have on the positioning of the heat dissipation material.

According to an embodiment of the disclosure, the heat dissipation member 350 may include heat dissipation particles. For example, the heat dissipation particles may include electrically insulating materials such as aluminum oxide (Al2O3) or aluminum nitride (AlN). In another example, the heat dissipation particles may include carbon fiber, graphene, boron nitride (BN), silicon carbide (SiC), magnesium oxide (MgO), or zinc oxide (ZnO).

According to an embodiment of the disclosure, the heat dissipation member 350 may include a phase change material. The phase change material may include a thermoresponsive material that reacts to temperature changes and may include a thermoplastic polymer (i.e. the phase change material may change or partially change state based on its temperature). For example, the phase change material may change from a solid to a gel or a liquid as a temperature increases (i.e. when its melting point or phase transition temperature is reached), and may include a paraffin-based material, which is a temperature-sensitive material. However, the phase change material may take any form which provides the required thermal characteristics (i.e. required phase change characteristics and/or thermal dissipation/conductivity characteristics) and is therefore not limited to paraffin-based materials. The use of the phase-change material may also lessen the required accuracy of the heat dissipation member 350 placement with respect to the heat generating components when the heat dissipation member 350 is in a solid phase, since when in a gel phase for example, there may be partially movement/expansion of the heat dissipation member 350 which provides improved contact/enclosure of the heat generating components compared to when the heat dissipation member 350 is in a solid phase.

According to an embodiment of the disclosure, the heat dissipation member 350 may include a matrix material configured to maintain the heat dissipation member 350 in a gel phase as opposed to a liquid phase when its melting point is passed. The matrix material may function as a frame for the heat dissipation member 350, allowing the heat dissipation member 350 to substantially maintain its shape even when its temperature increases. For example, the matrix material may include a rubber-based material.

According to an embodiment of the disclosure, the heat dissipation member 350 may include about 75 to 90 wight percentage (wt%) of the heat dissipation particles, about 5 to 15 wt% of the matrix material, and/or about 5 to 15 wt% of the phase change material. The composition ratio of the heat dissipation particles, matrix material, and/or phase change material included in the heat dissipation member 350 is not limited to the above examples such that the ratios may take any values that are suitable for providing a phase change material having an intended behaviour.

According to an embodiment of the disclosure, the substrate assembly 300 may include an interposer 330 disposed between the first surface 311 of the first substrate 310 and the third surface 321 of the second substrate 320. The first substrate 310 and the second substrate 320 may be electrically connected through the interposer 330. The interposer 330 may be electrically connected to the first substrate 310 through a first soldering portion 361, and to the second substrate 320 through a second soldering portion 362. For example, the interposer 330 may be connected to the first substrate 310 and the second substrate 320 through vias (not shown) included in the first substrate 310 and the second substrate 320.

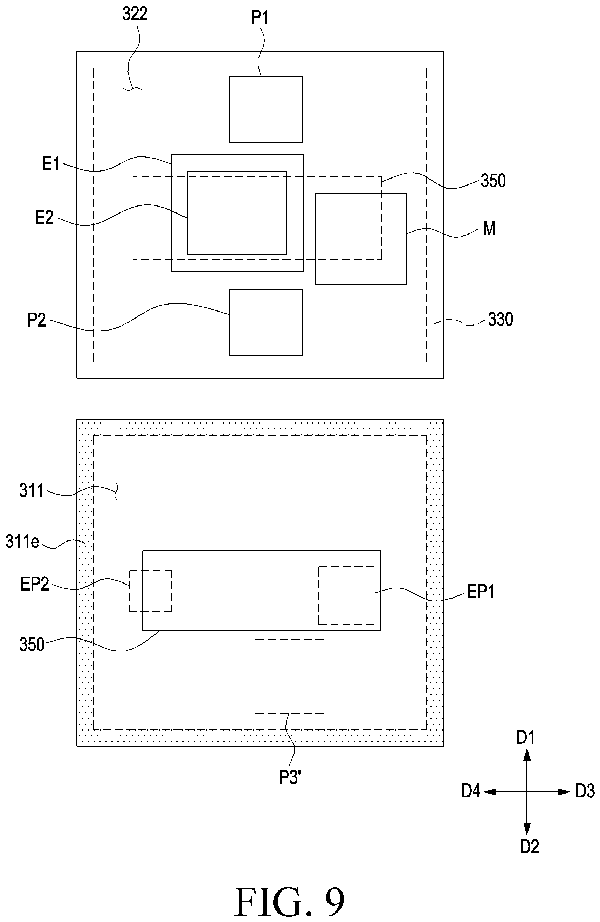

According to an embodiment of the disclosure, the interposer 330 may at least partially surround the heat dissipation member 350. For example, the interposer 330 may extend annularly along the edges of the first substrate 310 and the second substrate 320. More specifically, the interposer 330 may extend along the edge 311e (see FIG. 9) of the first surface 311 of the first substrate 310 and/or the edge of the third surface 321 of the second substrate 320. According to another embodiment (not shown) of the disclosure, the interposer 330 may partially surround the heat dissipation member 350. For example, the interposer 330 may entirely surround the heat dissipation member 350 together with other structures (e.g., sidewalls, etc.). In some examples, the interposer 330 may be formed by a plurality of interposer members.

According to an embodiment of the disclosure, the substrate assembly 300 may include an internal space 331 that is at least partially surrounded or at least partially defined by the first surface 311 of the first substrate 310, the third surface 321 of the second substrate 320, and the interposer 330. The heat dissipation member 350 may be disposed in the internal space 331 such that it completely or partially fills the internal space 311.

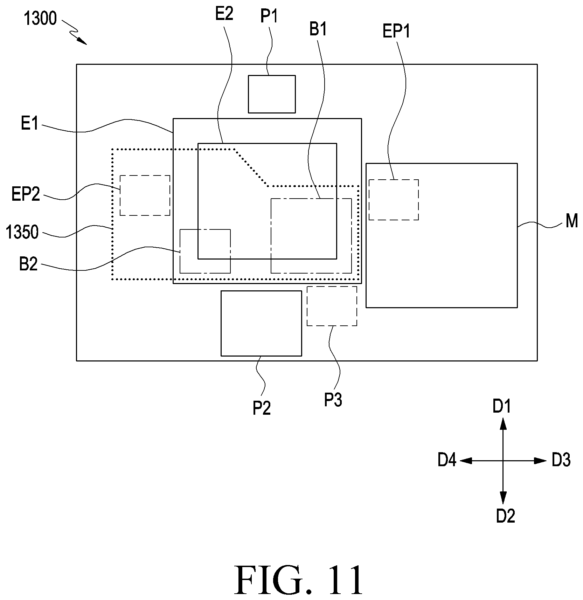

According to an embodiment of the disclosure, the electronic device 101 may include an electronic component E1 disposed on the fourth surface 322 of the second substrate 320. The electronic component E1 may generate heat during operation. For example, the electronic component E1 may be an application processor including multiple processing cores (e.g., the processing cores B1 and B2 of FIG. 11).

According to an embodiment of the disclosure, the electronic device 101 may include a volatile memory E2 disposed on the electronic component E1. The volatile memory E2 may be operatively connected to the electronic component E1. For example, it may be a dynamic random access memory (DRAM). In some examples, the volatile memory E2 may be disposed apart from the electronic component E1.

According to an embodiment of the disclosure, the electronic device 101 may include a shield can or shielding member 420 disposed on the fourth surface 322 of the second substrate 320. The shield can 420 may surround fully or partially the electronic component E1 and a volatile memory E2. The shield can 420 may be connected to a ground configuration (not shown) of the electronic device 101 through the substrate assembly 300. A hole/opening/window may be formed at the top surface of the shield can 420.

According to an embodiment of the disclosure, the electronic device 101 may include a shielding cover or shielding lid 440 that covers the hole of the shield can 420. The shielding cover 440 may be in contact with the shield can 420. As an example, the shielding cover 440 may be adhered to the shield can 420 by a conductive adhesive. The shielding cover 440 and the shield can 420 may shield noise generated by the electronic component E1. The shield can 420 and the shielding cover 440 may surround the electronic component E1, the volatile memory E2, and the heat dissipation material 430. The shielding cover 440 and/or shielding can 420 may also shield the electronic component E1 and/or volatile memory E2 from external electromagnetic radiation and/or contain electromagnetic radiation produced by the electronic component E1 and/or volatile memory E2.

According to an embodiment of the disclosure, the substrate assembly 300 may include a heat dissipation material 430 positioned between the volatile memory E2 and the shielding cover 440 and/or shielding can 420. The heat dissipation material 430 allows heat generated by the electronic component E1 and the volatile memory E2 to be transferred to the shielding cover 440 and/or shielding can 420. In some examples, the heat dissipation material 430 may be disposed fully or partially between the electronic component E1 and the shielding cover 440 and/or the shielding can 420.

According to an embodiment of the disclosure, the heat dissipation material 430 may have a predetermined viscosity. Due to this viscosity, the heat dissipation material 430 may for example remain within the space between the volatile memory E2 and the shielding cover 440, even if the electronic device 101 collides with an external structure. As an example, the heat dissipation material 430 may include heat dissipation particles (e.g., Al2O3 and/or AlN), additives (curing agents and/or catalysts), silicone resin, and/or silicone oil.

According to an embodiment of the disclosure, the electronic device 101 may include at least one communication component T1 or T2 disposed on the second surface 312 of the first substrate 310. The electronic device 101 may include a shield can or shield member 370 surrounding the communication components T1 and T2. FIG. 4 illustrates, for example, a state in which a first communication component T1 and a second communication component T2 are disposed inside the shield can 370. The shield can 370 may also be formed by a plurality of shield members.

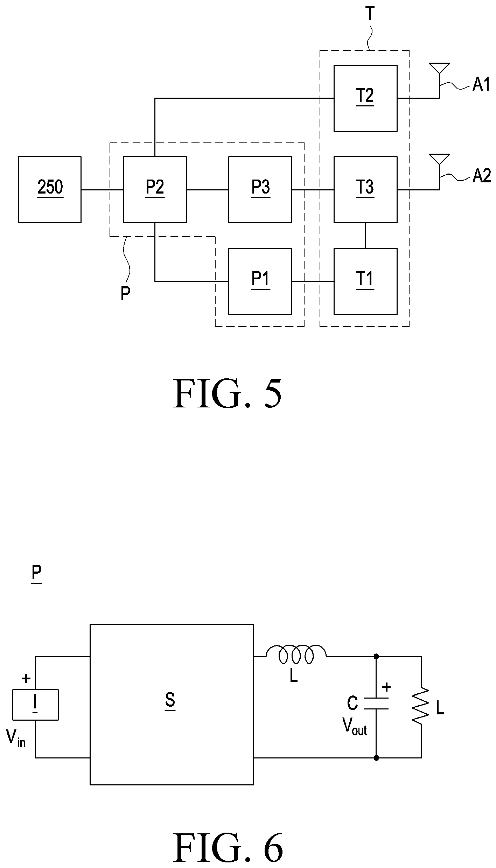

According to an embodiment of the disclosure, at least one communication component T1 or T2 may be implemented as part of communication circuitry T (see FIG. 5), such as the communication module 190 in FIG. 1. For example, the at least one communication component T1, T2, or T3 (see FIG. 5) may include an intermediate frequency integrated circuit (IFIC), a transceiver, a front-end module (FEM), and/or a power amplifier, which will be described in detail later.

FIG. 5 is a block diagram showing part of the electronic device 101, illustrating the communication circuitry T and the power management circuitry P according to an embodiment of the disclosure.

Referring to FIG. 5, the electronic device 101 according to an embodiment of the disclosure may include communication circuitry T (e.g., the communication module 190 in FIG. 1). The communication circuitry T may be connected to antennas A1 and A2 (e.g., the antenna module 197 in FIG. 1). For example, the communication circuitry T may determine which of the antennas A1 and A2 will receive radio waves from the outside or transmit radio waves to the outside, allowing the electronic device 101 to receive radio waves from the outside or transmit them through the antennas A1 and A2.

According to an embodiment of the disclosure, the communication circuitry T may include a first communication component T1, a second communication component T2, and/or a third communication component T3. The second communication component T2 may be connected to the first antenna A1. The third communication component T3 may be connected to the second antenna A2. For example, the second communication component T2 may include an intermediate frequency integrated circuit (IFIC), and the third communication component T3 may include a radio frequency integrated circuit (RFIC). Although three communication circuits T1, T2, T3 and two antennas A1, A2 are shown in FIG. 5, the electronic device 101 may have any number of these components and may take any suitable form.

According to an embodiment of the disclosure, the electronic device 101 may include power management circuitry P (e.g., the power management module 180 in FIG. 1) electrically connected to the communication circuitry T. The power management circuitry P is configured to supply power (e.g. voltage and/or current) to the communication circuitry T. The power management circuitry P may control the power supplied from the battery 250 to deliver power to the communication components T1, T2, and T3, or to a specific region of the communication circuitry T. The power management circuitry P may include first power management circuitry P1, second power management circuitry P2, and/or third power management circuitry P3, which is exemplary and not limited to this number.

According to an embodiment of the disclosure, the second power management circuitry P2 may perform functions of power supply, conversion, or current control from the battery 250 to supply power to the first power management circuitry P1, the third power management circuitry P3, or the second communication component T2. For example, the second power management circuitry P2 may include an intermediate frequency power management integrated circuit IF PMIC, and the second communication component T2 may include an intermediate frequency integrated circuit IFIC.

According to an embodiment of the disclosure, the second power management circuitry P2 may supply power to the first power management circuitry P1. The first power management circuitry P1 is configured to control the power supplied by the second power management circuitry P2 and to provide power to the first communication component T1. For example, the first power management circuitry P1 may include an envelope tracking modulator (ET Modulator), and the first communication component T1 may include a power amplifier.

According to an embodiment of the disclosure, the second power management circuitry P2 may supply power to the third power management circuitry P3. The third power management circuitry P3 is configured to control the power supplied by the second power management circuitry P2 and to provide power to the third communication component T3. For example, the third power management circuitry P3 may include a radio frequency power management integrated circuit (RF PMIC), and the third communication component T3 may include a radio frequency integrated circuit (RFIC).

FIG. 6 is a schematic diagram of power management circuitry P (e.g., the first power management circuitry P1, the second power management circuitry P2, or the third power management circuitry P3) illustrated in FIG. 5 according to an embodiment of the disclosure. The description of the power management circuitry P with reference to FIG. 6 may be substantially applied in the same manner to the first power management circuitry P1, the second power management circuitry P2, and the third power management circuitry P3, respectively, and for the sake of convenience in the explanation, it will be described below based on the power management circuitry P.

Referring to FIG. 6, the power management circuitry P according to an embodiment of the disclosure may include switching circuitry S. The switching circuitry S may receive power (Vin) from an input capacitor I or other component that may supply a power input. The switching circuitry S may include a switching element (e.g., a switching transistor). The power management circuitry P may be configured to control the on-off time ratio of the switching circuitry S to stabilize the supplied voltage Vin and deliver the stabilized voltage to the load L. As an example, the switching circuitry S may be implemented as at least part of an integrated circuit (e.g., a power management integrated circuit (PMIC)) including a switched-mode power supply (SMPS).

According to an embodiment of the disclosure, the power management circuitry P may include an output capacitor C. The power management circuitry P may supply power (Vout) to the load L (e.g., the communication circuitry T of FIG. 5) through the output capacitor C. The output capacitor C may be electrically connected to the switching circuitry S. The output capacitor C may stabilize the power output from the switching circuitry S and supply it to the load L.

According to an embodiment of the disclosure, when power is applied to the output capacitor C as the switching circuitry S is repeatedly controlled to turn on and off, vibration and noise may be generated in the output capacitor C. For example, the output capacitor C may include a ceramic capacitor comprising a dielectric with piezoelectric characteristics. When power is applied to the output capacitor C as a result of the on-off control of the switching circuitry S, the dielectric with piezoelectric characteristics may repeatedly contract and expand, causing the output capacitor C to vibrate. Additionally, the vibration generated in the output capacitor C may be amplified into audible noise perceptible to the user through the solid-phase heat dissipation member 350 as a medium.

According to an embodiment of the disclosure, for example, when the user's ear approaches a region of the electronic device 101 (e.g., the receiver hole 214 in FIG. 2) during a call, the capacitor noise coupled and/or amplified through the heat dissipation member 350 may be transmitted to (i.e. be audible to) the user. However, when the output capacitor C is disposed on the second surface 312 or the fourth surface 322, the audible noise may be reduced by arranging the output capacitor C, which is included in the power management circuitry P, and the heat dissipation member 350 so that they do not overlap. In another example, when the output capacitor C is disposed on the first surface 311 or the third surface 321, the transmission of the audible noise generated by the output capacitor C to the outside of the electronic device 101 may be suppressed by ensuring that the output capacitor C does not contact the heat dissipation member 350 and/or does not overlap the heat dissipation member 350. In other words, the audible effect of the output capacitor C on the user may be reduced by increasing a level of isolation (i.e. decreasing a level of acoustic coupling) between the output capacitor C (and/or the power management circuitry as a whole) and the outside of the electronic device 101 and/or heat dissipation member 350. Although an output capacitor C is referred to, other components of the power management circuitry that may cause noise and/or vibrations may be considered. Furthermore, components other than the power management circuitry or components thereof that cause noise and/or vibrations may also be appropriately positioned with respect to the heat dissipation member in order to reduce the transfer of noise to the user during a call or whilst the electronic device is otherwise operational (i.e. being used by the user or in an idle state). In some examples, a noise generating component (e.g. output capacitor or power management circuitry) may be disposed in space 331 between the first substate, the second substrate and the interposer that does not contain the heat dissipation member, outside the space defined by the first substate, the second substrate, and the interposer, or the noise generating components may be disposed across both of these areas so as not to overlap with the heat dissipation member.

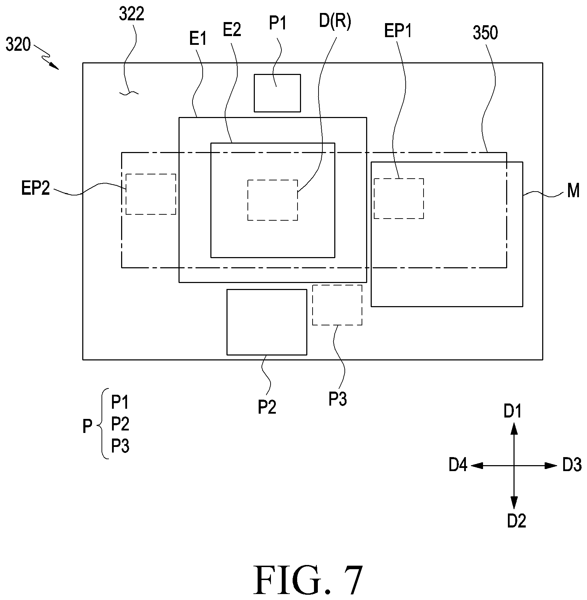

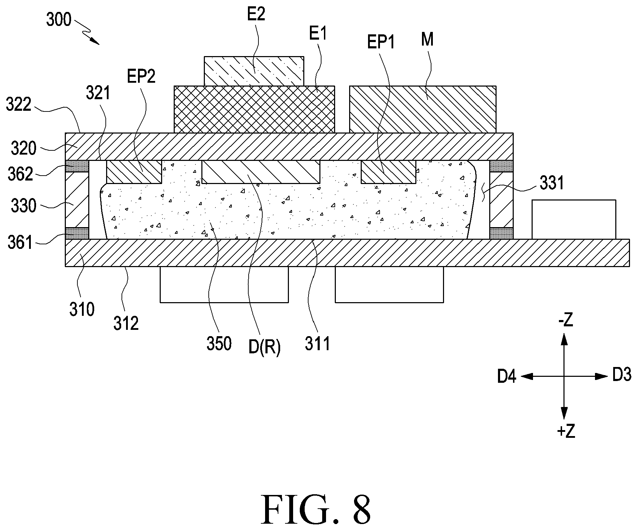

FIG. 7 is a plan view of part of the substrate assembly 300 according to an embodiment of the disclosure. FIG. 7 may be understood as a plan view of part of the substrate assembly 300 when viewed from above the fourth surface 322 of the second substrate 320 (towards the first substrate 310). FIG. 8 is a cross-sectional view of the substrate assembly 300 according to an embodiment of the disclosure. The description of the coordinate axes (+Z, -Z) with reference to FIG. 4 applies equally to the coordinate axes (+Z, -Z) shown in FIG. 8.

Referring to FIGS. 7 and 8, FIG. 7 illustrates coordinate axes including a plurality of directions D1, D2, D3, and D4, and FIG. 8 illustrates coordinate axes including a plurality of directions +Z, -Z, D3, and D4. The first direction D1 and the second direction D2 may be opposite to each other. The third direction D3 and the fourth direction D4 may be opposite to each other. As an example, the first direction D1 may be understood as the direction the Y-axis faces, as illustrated in FIGS. 2 and 3, and the second direction D2 may be understood as the direction opposite to the Y-axis, but is not limited to this. Similarly, the third direction D3 may be understood as the direction the X-axis faces, as illustrated in FIGS. 2 and 3, and the fourth direction D4 may be understood as the direction opposite to the X-axis, but is not limited to this.

Referring to FIGS. 7 and 8, according to an embodiment of the disclosure, the heat dissipation member 350 may at least partially overlap with the electronic component E1 when viewed from above the fourth surface 322 of the second substrate 320. The heat generated by the electronic component E1 may be transferred to the heat dissipation member 350 through the second substrate 320. The heat generated by the electronic component E1 may be effectively dissipated by the heat dissipation member 350.

According to an embodiment of the disclosure, when viewed from above the fourth surface 322 of the second substrate 320 (in a direction orthogonal to the fourth surface 322), the electronic component E1 may not overlap with the power management circuitry P. When viewed from above the fourth surface 322, the power management circuitry P may include first power management circuitry P1 spaced apart from the electronic component E1 in the first direction D1. The first power management circuitry P1 may be positioned around the first side (i.e. D1 side) of the electronic component E1.

According to an embodiment of the disclosure, the power management circuitry P may include second power management circuitry P2 spaced apart from the electronic component E1 in the second direction D2 when viewed from above the fourth surface 322 of the second substrate 320. The second power management circuitry P2 may be positioned around the second side (i.e. D2 side) of the electronic component E1.

According to an embodiment of the disclosure, the power management circuitry P may include third power management circuitry P3 spaced apart from the electronic component E1 in the second direction D2 when viewed from above the fourth surface 322 of the second substrate 320. The third power management circuitry P3 may be positioned around the second side (i.e. D2 side) of the electronic component E1. When viewed from above the fourth surface 322 of the second substrate 320, the third power management circuitry P3 may or may not overlap with the second power management circuitry P2. In other words, power management circuitry P1, P2 and/or P3 may be positioned on opposites sides of the heat dissipation member 350 or electronic component E1.

According to an embodiment of the disclosure, the power management circuitry P (e.g., the first power management circuitry P1, the second power management circuitry P2, and/or the third power management circuitry P3) may be disposed on the first substrate 310 or the second substrate 320. The power management circuitry P may be disposed on any of the first surface 311, second surface 312, third surface 321, or fourth surface 322. The output capacitor C (see FIG. 6) included in the power management circuitry P may be disposed on any of the first surface 311, second surface 312, third surface 321, or fourth surface 322. For example, the first power management circuitry P1 and the second power management circuitry P2 may be disposed on the fourth surface 322, and the third power management circuitry P3 may be disposed on the third surface 321. In another example, the first power management circuitry P1 and the second power management circuitry P2 may be disposed on the third surface 321, and the third power management circuitry P3 may be disposed on the first surface 311.However, any combination of power management circuitry and surface may be implemented. Furthermore, when viewed from above the fourth surface 322 (or any other of the surfaces), the power management circuitries may overlap when on the same surface and/or when on different surfaces.

According to an embodiment of the disclosure, the heat dissipation member 350 may overlap with the electronic component E1 and/or the non-volatile memory M when viewed from above the fourth surface 322 of the second substrate 320. When viewed from above the fourth surface 322, the power management circuitry P may not overlap with the heat dissipation member 350. When viewed in a direction orthogonal to the fourth surface 322, the output capacitor C (see FIG. 6) included in the power management circuitry P may not overlap with the heat dissipation member 350. For example, the footprint of the power management circuit P (or at least one noise-generating component thereof) and the heat dissipation member 350 may not overlap when viewed from above the fourth surface 322. The power management circuitries may be arranged on any of the surfaces whilst each not overlapping the heat dissipation member 350. Throughout this disclosure, the output capacitor or the power management circuitry as a whole that includes the output capacitor may be considered to be the noise generating component and therefore when an absence of an overlap is referred to this is referring to at least an output capacitor of the power management circuitry and/or at least one of the power management circuitries (P1, P2, P3).

According to an embodiment of the disclosure, the heat dissipation member 350 may be positioned between the first power management circuitry P1 and the second power management circuitry P2 when viewed from above the fourth surface 322, such that the power management circuitries P1 and P2 are around the outside of the heat dissipation member 350 when viewed from above the fourth surface 322. The heat dissipation member 350 may be positioned between the first power management circuitry P1 and the third power component P3 when viewed from above the fourth surface 322, such that the power management circuitries P1 and P3 are around the outside of the heat dissipation member 350 when viewed from above the fourth surface 322. The arrangements of FIGS. 7 and 8 allow the extent of the heat dissipation member 350 to be increased along the D4/D3 direction, thus providing increased overlap between the heat dissipation member 350 and non-noise-generating components (e.g. E1, E2, M, EP1, EP2). In other words, if the noise-generating components are positioned together or by only some of the sides of the heat dissipation member 350, the coverage of heat dissipation member 350 may be increased without resulting in overlap with the noise-generating components. For example, the extent of the heat dissipation member may not be constrained by the power management circuitry in the D3/D4 axis. This may therefore allow increased optimization/design freedom with respect to the placement of heat dissipation member (whilst also achieving reduced acoustic coupling of noise-generating components) and thus improved thermal management within the electronic device.

According to an embodiment of the disclosure, when viewed from above the fourth surface 322 of the second substrate 320, the non-volatile memory M may be spaced apart from the electronic component E1 in one direction (e.g., in the third direction D3). When viewed from above the fourth surface 322, the heat dissipation member 350 may overlap with the electronic component E1 and the non-volatile memory M, and may extend along the one direction (e.g., the third direction D3). When viewed from above the fourth surface 322, the plurality of power management circuitry P1, P2, and P3 may be spaced apart from the electronic component E1 in a direction (e.g., the first direction D1 or the second direction D2) substantially orthogonal to the one direction (e.g., the third direction D3). Accordingly, the arrangement of the electronic component E1, the non-volatile memory M, and the power management circuitry P1, P2, and P3 may be optimized, and the spatial efficiency of the substrate assembly 300 (see FIG. 4) may be increased whilst maintaining the non-overlap of the power management circuit P and the heat dissipation member 350.

According to an embodiment of the disclosure, the electronic device 101 may include power management components EP1 and EP2 (e.g., a power management integrated circuit (PMIC)) disposed on the second substrate 320. The power management components EP1 and EP2 may be configured to control the power supplied from the battery 250 (see FIG. 3) and provide it to the electronic component E1.

According to an embodiment of the disclosure, the power management components EP1 and EP2 may control the power supplied to the electronic component E1 in substantially the same manner as the power control method of the power management circuitry P described with reference to FIG. 6. For example, the power management components EP1 and EP2 may include switching circuitry (e.g., the switching circuitry S of FIG. 6).

According to an embodiment of the disclosure, the power management components EP1 and EP2 may be spaced apart from the electronic component E1 in the third direction D3 or the fourth direction D4 when viewed from above the fourth surface 322 of the second substrate 320 (in a direction orthogonal to the fourth surface 322). The power management components EP1 and EP2 may include a first power management component EP1 spaced apart from the electronic component E1 in the third direction D3. The power management components EP1 and EP2 may include a second power management component EP2 spaced apart from the electronic component E1 in the fourth direction D4. In some examples, power management components EP1 and EP2 may be spaced apart from the electronic component E1 in the first direction D1 or the second direction D2

According to an embodiment of the disclosure, when viewed from above the fourth surface 322 of the second substrate 320), the first power management component EP1 may be positioned around the third side D3 of the electronic component E1, which is between the first side D1 and the second side D2 of the electronic component E1. When viewed from above the fourth surface 322 of the second substrate 320, the second power management component EP2 may be positioned around the fourth side D4 of the electronic component E1, which is between the first side D1 and the second side D2 of the electronic component E1.

According to an embodiment of the disclosure, when viewed from above the fourth surface 322 of the second substrate 320, at least one of the first power management component EP1 and the second power management component EP2 may overlap with the heat dissipation member 350. When viewed from above the fourth surface 322 of the second substrate 320, at least one of the first power management component EP1 and the second power management component EP2 may not overlap with the electronic component E1. For example, FIGS. 7 and 8 illustrate an embodiment in which the first power management component EP1 and the second power management component EP2 overlap with the heat dissipation member 350 and do not overlap with the electronic component E1. In other words, whilst the power management circuity P that supplies power to the communication circuitry T does not overlap the heat dissipation member 350, the power management components EP1 and EP2 may or may not overlap the heat dissipation member 350.

According to an embodiment of the disclosure, the electronic device 101 may include a plurality of decoupling capacitors D configured to stabilize the power supplied to the electronic component E1. The plurality of decoupling capacitors D may be disposed on the third surface 321 of the second substrate 320. The plurality of decoupling capacitors D may be located at a region D shown in FIGS. 7 and 8. The decoupling capacitors D may be electrically connected to the electronic component E1 through the second substrate. For example, the decoupling capacitors D may be connected to the electronic component E1 through vias (not shown) included in the second substrate 320.

According to an embodiment of the disclosure, when viewed from above the fourth surface 322 of the second substrate 320, the decoupling capacitors D may overlap with the electronic component E1. When viewed from above the fourth surface 322 of the second substrate 320, the decoupling capacitors D may overlap with the heat dissipation member 350.

According to an embodiment of the disclosure, the electronic device 101 may include a non-volatile memory M disposed on the fourth surface 322 of the second substrate 320. The non-volatile memory M may be positioned around the electronic component E1. When viewed from above the fourth surface 322, the non-volatile memory M may not overlap with the electronic component E1. The non-volatile memory M may overlap with the first power management component EP1 when viewed from above the fourth surface 322.

FIG. 9 is a plan view of a first substrate 310 and a second substrate 320 according to another embodiment of the disclosure. The description of the coordinate axes D1, D2, D3, and D4 described with reference to FIG. 7 may equally apply to the coordinate axes D1, D2, D3, and D4 illustrated in FIG. 9.

The description of the third power management circuitry P3 described with reference to FIGS. 5 to 7 may be substantially the same for the third power management circuitry P3' of the same name illustrated in FIG. 9, as long as they are not arranged differently. The third power management circuitry P3' illustrated in FIG. 9 may differ from the third power management circuitry P3 illustrated in FIG. 7 in that the third power management circuitry P3' overlaps with the second power management circuitry P2.

Referring to FIG. 9, the power management circuitry P1, P2, and P3' according to another embodiment of the disclosure may be disposed on any of the first surface 311, the second surface 312, the third surface 321, or the fourth surface 322. When viewed from above the fourth surface 322 of the second substrate 320, the power management circuitry P1, P2, and P3' may not overlap with the heat dissipation member 350. When viewed from above the fourth surface 322 of the second substrate 320, the third power management circuitry P3' may overlap with the second power management circuitry P2. For example, the second power management circuitry P2 and the third power management circuitry P3' may each be disposed on one of the first surface 311, the second surface 312, the third surface 321, or the fourth surface 322, with the other disposed on a different surface. In other words, the power management circuitry may be arranged in any suitable position or overlapping arrangement with each other or other components if the power management circuitry does not overlap the heat dissipation member 350.

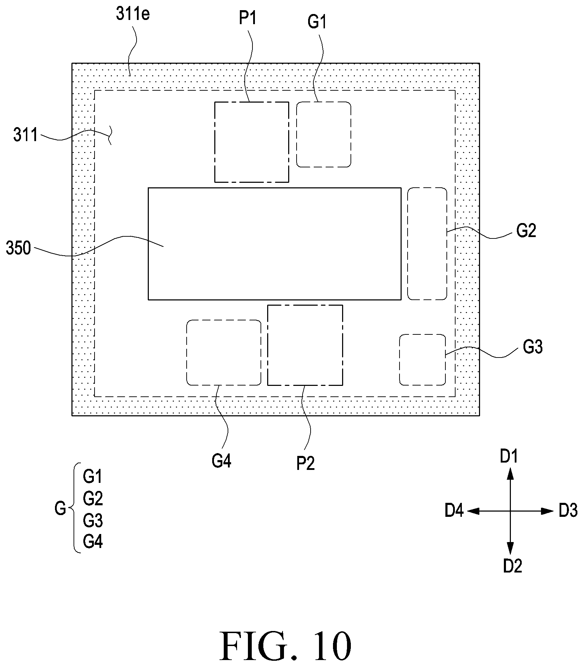

FIG. 10 is a plan view of the first substrate 310 according to an embodiment of the disclosure. The description of the coordinate axes D1, D2, D3, and D4 described with reference to FIG. 7 may equally apply to the coordinate axes D1, D2, D3, and D4 illustrated in FIG. 10.

According to an embodiment of the disclosure, the electronic device 101 may include at least one electronic element disposed on the first surface 311 of the first substrate 310 or the third surface 321 of the second substrate 320. FIG. 10 illustrates an example in which the at least one electronic element is disposed on the first surface 311 for convenience of explanation. The electronic elements may be disposed adjacent to each other to perform a predetermined function. A plurality of electronic elements disposed adjacent to each other may form electrical circuitry G for performing the predetermined function.

According to an embodiment of the disclosure, the substrate assembly 300 may include at least one electrical circuitry G1, G2, G3, and G4. The electrical circuitry G1, G2, G3, and G4 may be mounted on the first surface 311 of the first substrate 310. The electrical circuitry G1, G2, G3, and G4 may be positioned between the heat dissipation member 350 and the interposer 330. The electrical circuitry G1, G2, G3, and G4 may include a plurality of electrical elements. For example, the electrical element may include a capacitor, an inductor, or a transistor.

According to an embodiment of the disclosure, a plurality of electrical circuitry G1, G2, G3, and G4 may be disposed. At least one G3 of the plurality of electrical circuitry G1, G2, G3, and G4 may be disposed adjacent to the interposer 330. Accordingly, this arrangement allows more area for the heat dissipation member 350 on the first surface 311 of the first substrate 310, and the heat dissipation member 350 may be disposed over a larger area on the first surface 311.

According to an embodiment of the disclosure, when viewed from above the fourth surface 322 of the second substrate 320 or from above the first surface 311 of the first substrate 310, the plurality of electrical circuitry G1, G2, G3, and G4 may not overlap with the power management circuitry P1 and P2. Consequently, the height (e.g., the height in the Z-axis direction of FIG. 3) of the substrate assembly 300 may be minimized.

FIG. 11 is a plan view of a portion of the substrate assembly 1300 according to an embodiment of the disclosure. The description of the coordinate axes D1, D2, D3, and D4 described with reference to FIG. 7 may equally apply to the coordinate axes D1, D2, D3, and D4 illustrated in FIG. 11.

Referring to FIG. 11, according to an embodiment of the disclosure, the electronic component E1 may include a processor (e.g., an application processor, such as the processor 120 in FIG. 1) comprising a plurality of processing cores B1 and B2. The processing cores B1 and B2 may be a CPU or a GPU of the processor. When viewed from above the fourth surface 322 of the second substrate 320, the heat dissipation member 1350 may overlap with at least one of the plurality of processing cores B1 and B2 and may not overlap with the power management circuitry P1, P2, and P3. Accordingly, the heat dissipation member 1350 may be disposed to avoid overlapping with the power management circuitry P1, P2, and P3, which are noise-generating portions, while intensively dissipating heat from a region (e.g., the processing cores B1 and B2) where a large amount of heat is generated inside the electronic component E1. Consequently, the amount of the heat dissipation member 1350 can be reduced whilst maintaining or having a small reduction in the heat it transfers away from the electronic component E1.

Although a specific arrangement of components is shown and described with reference to FIGS. 4-11, the arrangement of components is not so limited and may be provided in any configuration where noise-generating power management circuitry (P) or a portion thereof and/or one or more of the noise-generating output capacitors (C) of the power management circuitry (P) does not overlap with the heat dissipation member. In some examples, the different power management circuitries (P1, P2, P3) and/or the output capacitors thereof may produce different levels of noise and the greater noise sources may not be overlapped with the heat dissipation member but lesser noise sources partially or fully overlap with the heat dissipation member. In other examples, one or more of the power management circuitries (P1, P2, P3) and/or the output capacitors thereof may not overlap with the heat dissipation member when the heat dissipation member is a solid phase but may at least partially overlap when the heat dissipation member is a non-solid phase due to movement and/or expansion of the heat dissipation member.

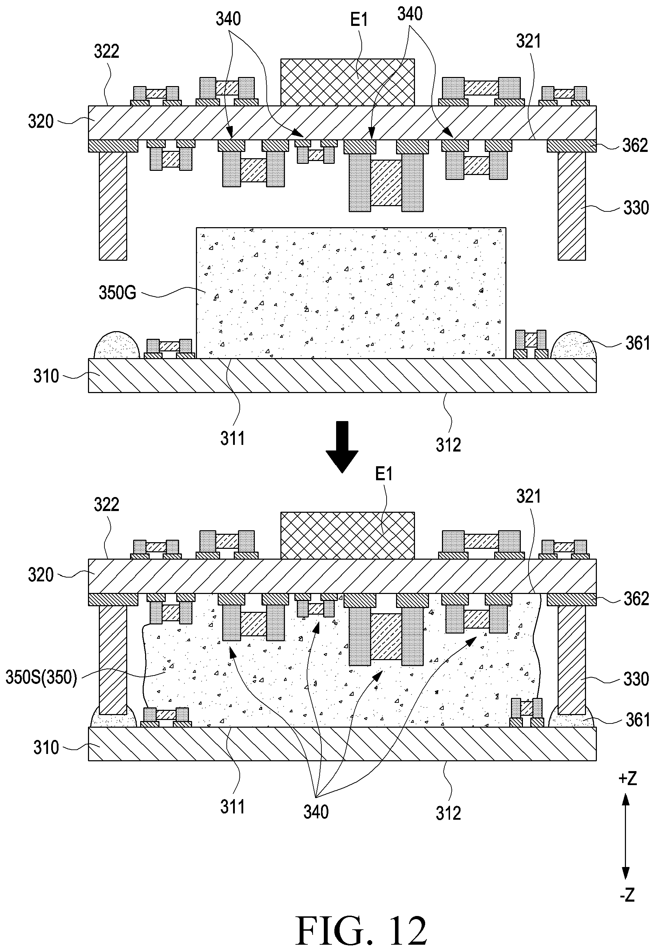

FIG. 12 illustrates part of the process of manufacturing the substrate assembly 300 according to an embodiment of the disclosure. The description of the coordinate axes (+Z, -Z) described with reference to FIG. 4 may equally apply to the coordinate axes (+Z, -Z) shown in FIG. 12.

The manufacturing process of the substrate assembly 300 shown in FIG. 12 is exemplary, and the manufacturing process of the substrate assemblies 300 or 1300 according to various embodiments of the disclosure is not limited to the method illustrated in FIG. 12.

Referring to FIG. 12, after the heat dissipation member 350 is pre-placed on the first substrate 310, reflow soldering is performed to bond the first substrate 310 and the interposer 320, thereby manufacturing the substrate assembly 300 with the heat dissipation member 350 disposed in the internal space 331 (see FIG. 4).

When the first substrate 310 is heated, with the heat dissipation member 350 disposed on the first surface 311 of the first substrate 310 and the solder solution 362 applied to the edge of the first surface 311 of the first substrate 310 (e.g., the edge 311e shown in FIGS. 9 and 10), the heat dissipation member 350G may at least partially enter a gel phase and soften.

When the pre-bonded interposer 330 and second substrate 320 are pressed, causing the soft gel-phase heat dissipation member 350G to be compressed, the heat dissipation member 350G in the gel phase may be further compressed as the first substrate 310 and the second substrate 320 move closer together. The compressed gel-phase heat dissipation member 350G may flow between the components 340 disposed on the third surface 321 of the second substrate 320 and contact the third surface 321.

Once the substrate assembly 300 is sufficiently cooled, the gel-phase heat dissipation member 350S disposed in the internal space 331 may transition from a gel phase to a solid phase. When heat is generated as the electronic component E1 operates, the heat dissipation member 350 may absorb the generated heat and at least partially soften, thereby allowing the heat of the electronic component E1 to be effectively dissipated through the heat dissipation member 350.

As the integration density and performance of electronic components (e.g., application processors) increase, the amount of heat generated by the electronic components is also increasing. If the temperature of the electronic components caused by heat generation is not reduced, the performance of the electronic device may be affected (e.g., performance degradation due to throttling). Accordingly, extensive research is being conducted on heat dissipation structures for electronic components.

The problem to be solved by the disclosure may be to provide a heat dissipation structure in which the arrangement of the heat dissipation member and the components around the heat dissipation member is optimized.

Another problem to be solved by the disclosure may be to prevent and/or reduce the vibration generated by an electrical element (e.g., a capacitor) from being amplified via the heat dissipation member acting as a medium.

The problems addressed by the disclosure are not limited to the aforementioned problems and may be extend in various ways without departing from the spirit and scope of the disclosure.

The electronic device according to various embodiments of the disclosure may provide a heat dissipation structure in which the arrangement of the heat dissipation member and the components around the heat dissipation member is optimized by compactly arranging the heat dissipation structure and the components around the heat dissipation member.

An electronic device according to various embodiments of the disclosure may reduce the amplification of vibrations generated by the electrical element via the heat dissipation member acting as a medium by arranging the heat dissipation member and the vibration-causing electrical element (e.g., a capacitor) so that they do not overlap.

The effects obtainable from the disclosure are not limited to the effects mentioned above, and other effects not mentioned may be clearly understood by those skilled in the art from the aforementioned description.

According to an embodiment of the disclosure, the electronic device 101 may include a first substrate 310 that comprises a first surface 311 and a second surface 312 opposed to the first surface.

According to an embodiment of the disclosure, the electronic device 101 may include a second substrate 320 that comprises a third surface 321 facing the first surface and a fourth surface 322 opposed to the third surface.

According to an embodiment of the disclosure, the electronic device 101 may include an interposer 330 disposed between the first surface and the third surface.

According to an embodiment of the disclosure, the interposer 330 may at least partially surround the heat dissipation member.

According to an embodiment of the disclosure, the electronic device 101 may include an electronic component E1 disposed on the fourth surface.

According to an embodiment of the disclosure, the electronic device 101 may include communication circuitry T comprising communication components T1, T2, and T3.

According to an embodiment of the disclosure, the electronic device 101 may include one or more power management circuitry P comprising switching circuitry S.

According to an embodiment of the disclosure, the power management circuitry P may include an output capacitor C configured to supply power provided by the switching circuitry S to the communication components T1, T2, and T3.

According to an embodiment of the disclosure, the electronic device 101 may include a heat dissipation member 350 that is in a solid phase at room temperature.

According to an embodiment of the disclosure, the heat dissipation member 350 may be disposed in a space defined by the first substrate, the second substrate, and the interposer, so as to overlap with the electronic component when viewed in a direction orthogonal to the fourth surface.

According to an embodiment of the disclosure, the output capacitor C of the one or more power management circuitry P may be disposed on either the first substrate or the second substrate.

According to an embodiment of the disclosure, the output capacitor C of the one or more power management circuitry P may be disposed on one of the first surface 311, the second surface 312, the third surface 321, or the fourth surface 322.

According to an embodiment of the disclosure, the output capacitor C of the one or more power management circuitry P may not overlap with the heat dissipation member 350 when viewed in a direction orthogonal to the fourth surface.

According to an embodiment of the disclosure, the heat dissipation member 350 may include a paraffin-based phase change material that is in a solid phase at room temperature.

According to an embodiment of the disclosure, the heat dissipation member 350 may include a matrix material configured to maintain the heat dissipation member in a gel phase at a temperature higher than the melting point of the phase change material.

According to an embodiment of the disclosure, audible noise generated by the output capacitor C of the one or more power management circuitry P1, P2, and P3 may be suppressed from being transmitted to the outside of the electronic device by the output capacitor of the one or more power management circuitry not being in contact with the heat dissipation member.

According to an embodiment of the disclosure, the output capacitor may include a dielectric having piezoelectric characteristics.

According to an embodiment of the disclosure, the heat dissipation member may not overlap with the output capacitor of the power management circuitry when viewed from above the fourth surface.

According to an embodiment of the disclosure, the heat dissipation member may be in contact with the first surface.

According to an embodiment of the disclosure, the heat dissipation member may be in contact with at least one of the third surface or at least one component 340 disposed on the third surface.

According to an embodiment of the disclosure, the one or more power management circuitry may include at least one of a radio frequency power management integrated circuit (RF PMIC, P3), an envelope tracking modulator (ET modulator, P1), or an intermediate frequency power management integrated circuit (an IF PMIC, P2).

According to an embodiment of the disclosure, the electronic component may not overlap with the one or more power management circuitry when viewed in a direction orthogonal to the fourth surface.

According to an embodiment of the disclosure, the one or more power management circuitry may include first power management circuitry P1 positioned around a first side D1 of the electronic component when viewed in a direction orthogonal to the fourth surface.

According to an embodiment of the disclosure, the one or more power management circuitry may include second power management circuitry P2 positioned around a second side D2 of the electronic component, opposite to the first side, when viewed in a direction orthogonal to the fourth surface.

According to an embodiment of the disclosure, when viewed in a direction orthogonal to the fourth surface, the heat dissipation member may be located between the first power management circuitry and the second power management circuitry.

According to an embodiment of the disclosure, the electronic device 101 may include a power management component EP1 disposed on the second substrate and configured to control the power supplied to the electronic component.

According to an embodiment of the disclosure, the power management component may be positioned around the third side D3 of the electronic component, which is between the first side D1 and the second side D2, when viewed from above the fourth surface.

According to an embodiment of the disclosure, the power management component may overlap with the heat dissipation member when viewed from above the fourth surface.

According to an embodiment of the disclosure, the heat dissipation member may be attached to the first surface of the first substrate.

According to an embodiment of the disclosure, the heat dissipation member may be in contact with the third surface of the second substrate.

According to an embodiment of the disclosure, the electronic device 101 may include electrical circuitry G1, G2, G3, and G4, which comprises a plurality of electrical elements disposed on the first surface or the third surface.

According to an embodiment of the disclosure, the electrical circuitry G1, G2, G3, and G4 may be located closer to the interposer than the heat dissipation member.

According to an embodiment of the disclosure, the one or more power management circuitry may be disposed on the first surface or the third surface and located closer to the interposer than the heat dissipation member.

According to an embodiment of the disclosure, the electronic component may include a processor (e.g., an application processor) comprising a plurality of processing cores B1 and B2.

According to an embodiment of the disclosure, the heat dissipation member may overlap with at least one of the plurality of processing cores when viewed in the direction orthogonal to the fourth surface.

According to an embodiment of the disclosure, the electronic device 101 may include power management components EP1 and EP2 disposed on the second substrate and configured to control the power supplied to the electronic component.

According to an embodiment of the disclosure, the power management components may overlap with the heat dissipation member when viewed in the direction orthogonal to the fourth surface.

According to an embodiment of the disclosure, the power management components may not overlap with the electronic component when viewed in the direction orthogonal to the fourth surface.

According to an embodiment of the disclosure, the electronic device 101 may include a decoupling capacitor D configured to stabilize the power supplied to the electronic component.

According to an embodiment of the disclosure, the decoupling capacitor D may be disposed on the third surface to overlap with the electronic component when viewed from above the fourth surface.

According to an embodiment of the disclosure, the decoupling capacitor may overlap with the heat dissipation member when viewed in the direction orthogonal to the fourth surface.

According to an embodiment of the disclosure, the electronic device 101 may include a non-volatile memory M disposed on the fourth surface.

According to an embodiment of the disclosure, the non-volatile memory M may be positioned around the electronic component.

According to an embodiment of the disclosure, the non-volatile memory may overlap with the power management component when viewed from above the fourth surface.

According to an embodiment of the disclosure, the non-volatile memory may not overlap with the electronic component when viewed from above the fourth surface.

According to an embodiment of the disclosure, the electronic device may include a volatile memory E2 disposed on the electronic component.

According to an embodiment of the disclosure, the electronic component may include an application processor comprising a plurality of processing cores B1 and B2, and may be operatively connected to the volatile memory.

While the disclosure has been described with reference to specific embodiments and examples, it will be apparent to those skilled in the art that various modifications in form and detail may be made without departing from the scope of the disclosure.

Furthermore, although features are described in combination in this disclosure, the scope of the disclosure is not limited to such combinations. In particular, this disclosure covers alternative combinations unless noted as incompatible and features may be omitted from the combinations described herein, for example, when features do not directly interact with other features/components of an embodiment and/or are not required to achieve the advantage of the embodiment. Features that have been described separately may also be combined to form one or more embodiments.

## Claims

1. An electronic device comprising:
a first substrate (310) comprising a first surface (311) and a second surface (312) opposed to the first surface;
a second substrate (320) comprising a third surface (321) facing the first surface and a fourth surface (322) opposed to the third surface;
an interposer (330) disposed between the first surface and the third surface;
an electronic component (E1) mounted on the fourth surface;
communication circuitry (T) comprising a communication component (T1, T2, T3);
one or more power management circuitry (P) comprising switching circuitry (S), and an output capacitor (C) configured to supply power supplied from the switching circuitry (S) to the communication component (T1, T2, T3); and
a heat dissipation member (350) being in a solid phase at room temperature and disposed in a space defined by the first substrate, the second substrate, and the interposer so as to overlap with the electronic component when viewed in a direction orthogonal to the fourth surface,
wherein the output capacitor (C) of the one or more power management circuitry (P) is disposed on the first substrate or the second substrate and does not overlap with the heat dissipation member when viewed in the direction orthogonal to the fourth surface.

2. The electronic device of claim 1,
wherein the heat dissipation member (350) comprises:
a paraffin-based phase change material that is in the solid phase at room temperature; and
a matrix material configured to maintain the heat dissipation member in a gel phase at a temperature higher than a melting point of the phase change material.

3. The electronic device of claim 1 or 2,
wherein the output capacitor (C) is spaced apart from the heat dissipation member (350) to reduce acoustic coupling between the output capacitor (C) and the heat dissipation member (350).

4. The electronic device of any one of claims 1 to 3,
wherein the output capacitor comprises a dielectric having a piezoelectric characteristic.

5. The electronic device of any one of claims 1 to 4,
wherein the heat dissipation member (350) is in contact with the first surface and in contact with at least one of the third surface or at least one component (340) disposed on the third surface.

6. The electronic device of any one of claims 1 to 5,
wherein the one or more power management circuitry (P) comprises at least one of a radio frequency power management integrated circuit (RF PMIC, P3), an envelope tracking modulator (ET Modulator, P1), and an intermediate frequency power management integrated circuit (IF PMIC, P2).

7. The electronic device of any one of claims 1 to 6,
wherein, when viewed in the direction orthogonal to the fourth surface, the electronic component does not overlap with the one or more power management circuitry.

8. The electronic device of any one of claims 1 to 7,
wherein the one or more power management circuitry comprises:
first power management circuitry (P1) positioned at a first side (D1) of the electronic component when viewed in the direction orthogonal to the fourth surface; and
second power management circuitry (P2) positioned at a second side (D2) of the electronic component, opposite to the first side, when viewed in the direction orthogonal to the fourth surface,
wherein, when viewed in the direction orthogonal to the fourth surface, the heat dissipation member is positioned between the first power management circuitry and the second power management circuitry.

9. The electronic device of claim 8, further comprising a power management component (EP1) mounted on the second substrate and configured to control power supplied to the electronic component,
wherein, when viewed in the direction orthogonal to the fourth surface:
the power management component is positioned at a third side (D3) of the electronic component between the first side and the second side, and
the power management component overlaps with the heat dissipation member.

10. The electronic device of any one of claims 1 to 9,
wherein the heat dissipation member is attached to the first surface of the first substrate and in contact with the third surface of the second substrate.

11. The electronic device of any one of claims 1 to 10, further comprising:
electrical circuitry (G1, G2, G3, G4) that comprises a plurality of electrical elements mounted on the first surface or the third surface, and that is located closer to the interposer than the heat dissipation member.

12. The electronic device of any one claims 1 to 11,
wherein the one or more power management circuitry is mounted on the first surface or the third surface, and is located closer to the interposer than the heat dissipation member.

13. The electronic device of any one of claims 1 to 8 and claims 10 to 12, further comprising a power management component (EP1, EP2) mounted on the second substrate and configured to control the power supplied to the electronic component,
wherein, when viewed in the direction orthogonal to the fourth surface, the power management component overlaps with the heat dissipation member and does not overlap with the electronic component.

14. The electronic device of claim 13, further comprising a decoupling capacitor (D) configured to stabilize the power supplied to the electronic component, the decoupling capacitor being mounted on the third surface to overlap with the electronic component when viewed in the direction orthogonal to the fourth surface,
wherein, when viewed in the direction orthogonal to the fourth surface, the decoupling capacitor overlaps with the heat dissipation member.

15. The electronic device of claim 13, further comprising a non-volatile memory (M) mounted on the fourth surface and located adjacent to the electronic component,
wherein, when viewed in the direction orthogonal to the fourth surface, the non-volatile memory overlaps with the power management component and does not overlap with the electronic component.
